# EUROPEAN PATENT APPLICATION

(11) **EP 0 744 886 A1**
(43) Date of publication of application: **27.11.1996**
(21) Application number: 96303630.6
(22) Date of filing: 21.05.1996
(51) Int. Cl.: H05K 7/14, H01H 1/58

(54) **Structure for holding switching board in small size electronic appliance**

(30) Priority: 22.05.1995 JP 122183/95
(71) Applicant: NEC CORPORATION, Tokyo (JP)
(72) Inventor: Amano, Hiroshi, Kakegawa-shi, Shizuoka (JP); Yamada, Hiroshi, Kakegawa-shi, Shizuoka (JP)
(74) Representative: Abnett, Richard Charles

(57) **Abstract**

In a structure for holding a switching board (3) within a housing body (40) of a small size electronic appliance, the housing body is constituted of a substantially box-shaped case (1) having holes (16) in the bottom face thereof for locking switch-operating push-buttons (6) thereinto and a cover (2) with which the case is covered. The switching board mounts switch parts (10) to be pushed down through the corresponding buttons. At least one elastic projection (7) is provided nearby the holes on the bottom of the case and extends towards the opening side of the case. The tip of each projection (7) is formed into a claw hook shape, so that the switching board (3) is locked with the projection in the neighbourhood of the switch parts (10), thus holding the switching board without deflection even when pushing down the buttons (6). By using such a structure, the switching board (3) is held in the neighbourhood of the switch parts (10), and this makes it possible to prevent the deflection of the switching board in the push-down direction of the buttons (6), resulting in secure switching operation and rigid clicking touch of the buttons.

## Description

### BACKGROUND OF THE INVENTION

### 1. Field of the Invention

This invention relates to a structure of a small size electronic appliance and, more particularly, to a structure for holding a printed board within a housing body of the small size electronic appliance, the printed board mounting switch parts thereon (hereinafter, referred as to a switching board).

### 2. Description of the Prior Art

The main object of such a holding structure of the switching board in the small size electronic appliance is to hold the switching board with less deflection even when pushing down a switch operating button.

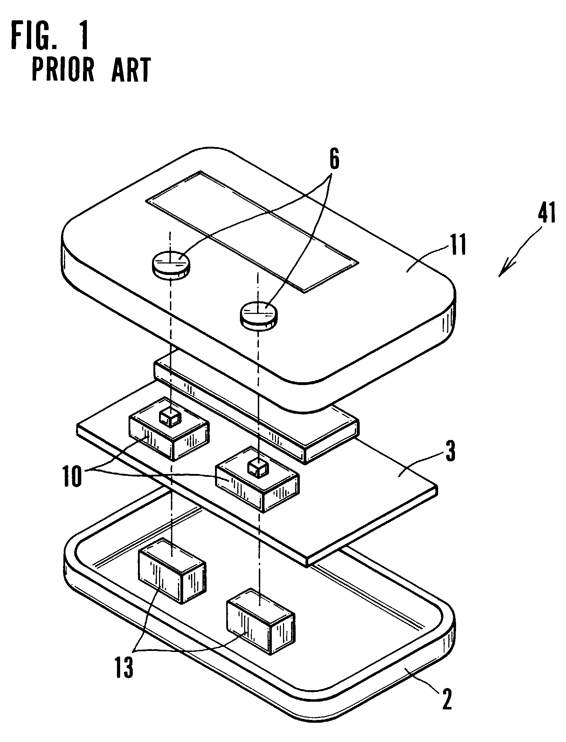

Fig. 1 is an exploded perspective view showing a first prior art of a structure for holding the switching board in the small size electronic appliance. As shown in Fig. 1, a housing body 41 of the small size electronic appliance is constituted of a substantially box-shaped case 11 one face of which is open and a cover 2 with which the opening side of the case 11 is covered, so that a switching board 3 mounting switches 10 on the face of the case 11 side is held within the housing body 41.

In the first prior art, ribs (not shown) and block members 13 are inserted between the switching board 3 and the cover 2 for supporting the switching board 3 to be held within the housing body 41. In operation, the switches 10 are changed over from one to another by pushing down either of buttons 6 provided on the case 11 so that a corresponding switch 10 on the switching board 3 can be pushed down.

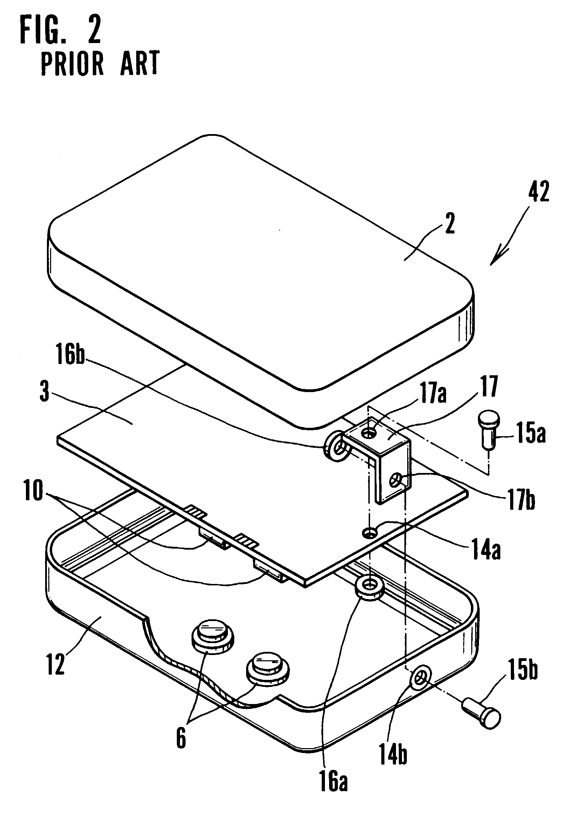

Fig. 2 is an exploded perspective view showing a second prior art of a structure for holding the switching board in the small size electronic appliance. As shown in Fig. 2, a housing body 42 of the small size electronic appliance is constituted of a substantially box-shaped case 12 one face of which is open and a cover 2 with which the opening side of the case 11 is covered, so that the switching board 3 mounting switches 10 on the face of the case 12 side is held within the housing body 42. Fig. 2 describes the case 12 and the cover 2 constituting a housing body 42 on the down side and the up side, respectively, by contrast to Fig. 1 for the purpose of an easy understanding. It should be noted that the case 12 and the cover 2 are generally put on the up side and down side, respectively.

In the second prior art, the switching board 3 is held within the housing body 42 by the provision of retaining holes 14a and 14b made in the switching board 3 and the side wall of the case 12, respectively, and angle type metal plate 17 having retaining holes 17a and 17b made in respective plate faces. The metal plate or lock plate 17 is fixed onto the switching board 3 by fastening a lock bolt 15a with a lock nut 16a through the retaining hole 17a of the lock plate 17 and the retaining hole 14a of the switching board 3. The switching board 3 is then fixed to the case 12 by fastening a lock bolt 15b with a lock nut 16b through the retaining holes 14b and 17b. In operation, the switches 10 are changed over from one to another by pushing down either of buttons 6 so that a corresponding switch 10 can be pushed down.

In either case, the rib and block member assembly or the lock plate provided for holding the switching board tend to disturb the insertion of other board or parts between the switching board and the cover. For this reason, the retaining members such as ribs and block members can not be provided between the switching board and the cover when other board or parts need to be equipped between the switching board and the cover. In this case, the switching board deflects due to a force by pushing down a switch through a corresponding button provided on the case, and this makes it hard to click the switch. Accordingly, a problem arises that the switch can not be pushed down securely. Further, the conventional structures for holding the switching board are not cost-efficient due to an increasing number of parts to be used as well as an increasing number of process steps in the assembly.

### SUMMARY OF THE INVENTION

An object of the present invention is to provide a structure for holding a switching board in a small size electronic appliance, capable of holding the switching board tightly without disturbing clicking touch of switches even when other board or parts are equipped between the cover and the back face of the switching board (i.e., the face on the cover side) so that the switches can be pushed down securely through corresponding switch operating buttons.

According to the present invention, the above object is accomplished by the provision of a structure for holding a switching board within a housing body of a small size electronic appliance, the housing body constituted of a substantially box-shaped case having holes in the bottom face thereof for locking switch operating push-buttons thereinto and a cover with which the case is covered, the switching board mounting switch parts to be pushed down through the corresponding buttons, characterized by at least one elastic projection provided nearby the holes on the bottom of the case and extending toward the opening side of the case, the tip of which is formed into a claw hook shape, so that the switching board is locked with the projection in the neighborhood of the switch parts, thus holding the switching board without deflection even when pushing down the buttons.

By using such a structure, the switching board is held in the neighborhood of the switch parts, and this makes it possible to prevent the deflection of the switching board in the push-down direction of the buttons, resulting in secure switching operation and rigid clicking touch of the buttons.

Further, the present invention provides a space between the switching board and the cover for equipping other printed board and/or parts, so that other printed board and/or parts can be easily equipped between the switching board and the cover.

Furthermore, if ribs are provided on the inner face of the side walls of the case, the switching board can be held more securely.

On the other hand, where at least one retaining hole is provided in the switching board for locking the projection thereinto so that the switching board is held within the housing body, the switching board can be held securely even when the buttons and the corresponding switch parts are provided nearby the center of the case and the center of the switching board, respectively.

The projection and the case are formed in a body, and this makes it possible to reduce the number of parts constituting the small size electronic appliance as well as the number of process steps in the assembly, resulting in easy assembly work.

### BRIEF DESCRIPTION OF THE DRAWINGS

The above and other objects and features of the invention are apparent to those skilled in the art from the following preferred embodiments thereof when considered in conjunction with the accompanied drawings, in which:
Fig. 1 is an exploded perspective view showing a first conventional structure for holding a switching board in a small size electronic appliance;
Fig. 2 is an exploded perspective view showing a second conventional structure for holding the switching board in the small size electronic appliance;
Fig. 3 is an exploded perspective view showing a structure for holding the switching board in the small size electric appliance according to an embodiment of the present invention;
Fig. 4 is a cross-sectional view of the embodiment in Fig. 3; and
Fig. 5 is a cross-sectional view showing a structure for holding the switching board in the small size electric appliance according to another embodiment of the present invention.

### DETAILED DESCRIPTION OF PREFERRED EMBODIMENTS

Referring to the drawings, the present invention will be described below.

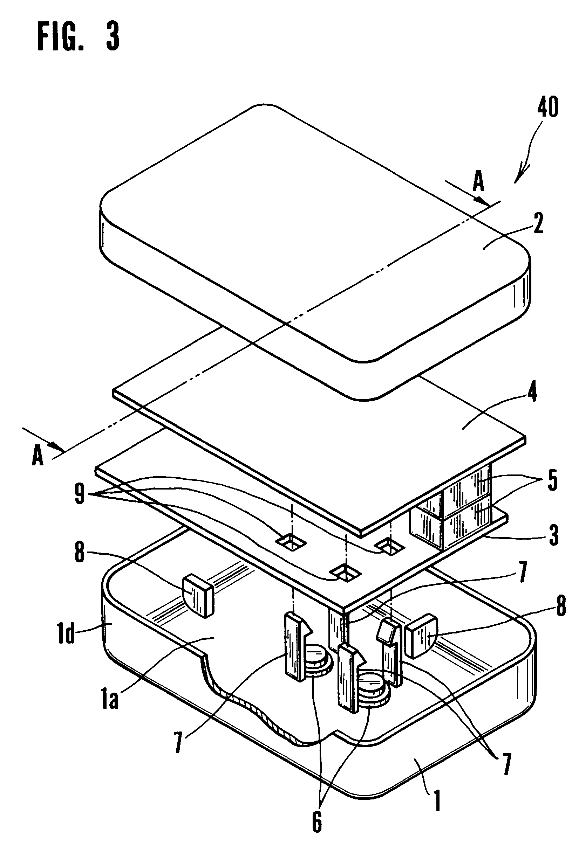

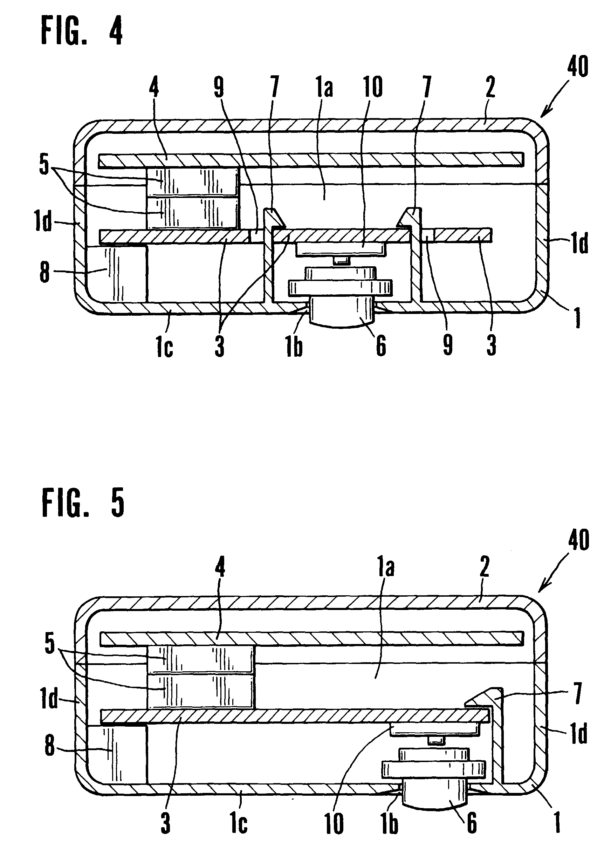

In the drawings, Fig. 3 is an exploded perspective view showing a structure for holding a switching board in a small size electronic appliance according to an embodiment of the present invention; Fig. 4 is a cross-sectional view of the embodiment in Fig. 3, taken along the line A-A; and Fig. 5 is a cross-sectional view of another embodiment of the present invention, taken along the line similar to that of Fig. 4. Although Figs. 3 to 5 describe a case 1 and a cover 2 constituting a housing body 40 on the down side and the up side respectively in the same way as Fig. 2 for the purpose of an easy understanding, the case 1 and the cover 2 are generally put on the up side and the down side, respectively. It should be also noted that no switch 10 is shown in Fig. 3.

As shown in Figs. 3 and 4, the housing body 40 of the small size electronic appliance is constituted of a substantially box-shaped case 1 one side of which is open and the cover 2 for covering the opening side of the case 1 (hereinafter, referred as to the opening portion la). As shown in Fig. 4, a hole 1b is made in the bottom face 1c of the case 1 so that a switch operating button 6 can be provided through the hole 1b. The case 1 is also provided with four projections 7 on the inner face nearby the hole 1b for the button 6, each tip of the projections formed into a claw hook shape and extending toward the opening portion la. The projections 7 are made of an elastic material so as to apply a force having the tendency of returning to the bottom face 1c against the force applied in the direction of the opening portion 1a.

On the other hand, a switching board 3 mounting switches 10 in positions opposite to the buttons 6 has four retaining holes 9 nearby the switches 10 and the four projections 7 are locked into the four holes 9, respectively, so that the switches 10 and the buttons 6 provided on the case 1 stand opposite each other, thus holding the switching board 3 due to an elastic action of the projections 7, i.e., due to the force applied in the direction of the face lc. The switching board 3 is connected through a connector 5 to other board 4 on which no switch part is mounted. The housing body 40 having a substantially box shape is finally assembled by covering the opening portion la of the case 1 with the cover 2.

In this case, no means (interfering object) for supporting and holding the switching board 3 resides between the cover 2 and the switching board 3, so that other board 4 and other necessary parts can be easily equipped within the housing body 40.

In the embodiment, the case 1 and the projections 7 provided on the inner face of the case 1 are unitarily formed of plastic. The claw hook shaped tips of the projections 7 locked into the respective holes 9 prevent the deflection of the switching board 3 toward the opening portion la, while the ribs 8 position the switching board 3 not to come down therefrom, thus holding the switching board 3.

According to the embodiment, when a button 6 is pushed down so that a corresponding switch 10 can be pushed down, although the switching board 3 tends to deflect upwardly due to push-down forces, as shown in Figs. 3 and 4, the push-down force of the button 6 acts on the switch 10 without serious losses since the projections 7 locked into the retaining holes 9 nearby the switches 10 prevent the deflection of the switching board 3. Accordingly, the switches 10 can be changed securely from one to another by pushing down the corresponding buttons 6. Further, a user or operator can operate the buttons 6 with rigid clicking touch.

Fig. 5 is a cross-sectional view showing another embodiment of the present invention. In this embodiment, a description will be made only to portions different from the embodiment shown in Figs. 3 and 4, omitting the description of the same portions.

As shown in Fig. 5, this embodiment of the present invention provides the button 6 in a position closer to the side wall ld of the case 1 than that of Fig. 4. Although the elastic projection 7 having the tip of a claw hook shape is provided nearby the hole 1b on the face lc of the case 1 opposite to the opening side and extends toward the opening portion la in the same way as in Figs. 3 and 4, the projection 7 to be used herein is one or two in number and is arranged along the side wall 1d of the case 1 since the hole 1b is made closer to the side wall of the case 1 than the embodiment shown in Figs. 3 and 4. Further, the switching board 3 mounts the switch 10 nearby one end side thereof, so that the four retaining holes 9 do not need to be made as they appear in the foregoing embodiment.

According to such a structure, the switching board 3 is locked with the projection 7 at one end side near the switch 10, while the other end side thereof strikes the ribs 8, so that the switching board 3 is positioned and held within the case 1. The push-down operation of the button 6 is accompanied by the action for preventing the deflection of the switching board 3 in the same way as the aforementioned embodiment.

As described above, although the embodiments described the projections 7 and the case 1 formed in a body, the present invention is not limited thereto. For example, the projections 7 may be formed of an elastic material separately from the case 1 and attached to the case 1 through proper fastening means.

## Claims

1. A structure for holding a switching board (3) within a housing body (40) of a small size electronic appliance, the housing body constituted of a substantially box-shaped case (1) having one or more holes (16) in the bottom face thereof for locking one or more switch operating push-buttons (6) thereinto and a cover (2) with which the case is covered, the switching board (3) mounting switch parts (10) to be pushed down through the corresponding buttons, characterised in that at least one elastic projection (7) is provided nearby said hole(s) on the bottom face (1c) of said case and extends toward the opening side of said case, the tip of which is formed into a claw hook shape, so that said switching board (3) is locked with said projection in the neighbourhood of the switch parts (10), thus holding said switching board without deflection even when a button is pushed down.

2. A structure according to claim 1, wherein a space is provided for mounting another printed board (4) and/or other components between said switching board (3) and said cover (2).

3. A structure according to claim 1 or 2, wherein ribs (8) are provided on the inner face of the side walls of said case for supporting end sides of said switching board.

4. A structure according to claim 1, 2 or 3, wherein at least one retaining hole (9) is provided in said switching board (3) for retaining said projection (7), so that said switching board is held within said housing body (40) by locking said projection into said retaining hole.

5. A structure according to any of claims 1 to 4, wherein said projection (7) and said case (1) are integrally formed in a body.
